Europäisches Patentamt

European Patent Office

Office européen des brevets

(19)

(11) Publication number: **0 353 120**
**A1**

(12) # EUROPEAN PATENT APPLICATION

(21) Application number: **89401978.5**

(22) Date of filing: **10.07.89**

(51) Int. Cl.⁵: **H 01 L 21/60**
**H 01 L 21/90, H 01 L 23/52**

(30) Priority: **25.07.88 JP 185005/88**

(43) Date of publication of application:
**31.01.90 Bulletin 90/05**

(84) Designated Contracting States: **DE FR GB**

(71) Applicant: **FUJITSU LIMITED**
**1015, Kamikodanaka Nakahara-ku**
**Kawasaki-shi Kanagawa 211 (JP)**

(72) Inventor: **Inoue, Minoru**
**Hainesu Mizonokuchi 418-1, Hisamoto Takatsu-ku**
**Kawasaki-shi Kanagawa 213 (JP)**

(74) Representative: **Joly, Jean-Jacques et al**
**CABINET BEAU DE LOMENIE 55, rue d'Amsterdam**
**F-75008 Paris (FR)**

(54) **A method of forming a barrier layer between a silicon substrate and an aluminium electrode of a semiconductor device.**

(57) A titanium nitride barrier layer of 50 to 200 nm in thickness is fabricated between a silicon substrate and an aluminum electrode layer of an IC device by reactive sputtering performed in a mixed gas including an oxygen gas having a flow ratio of 1 to 4% to other gases consisting of an argon gas and a nitrogen gas, setting a temperature of the silicon substrate to 350 to 550°C (C - A) so as to have characteristics that a failure rate indicating a property of preventing mutual diffusion of silicon and aluminum atoms from occurring is less than 1% and resistivity is less than 100 $\mu\Omega \cdot cm$.

FIG. 5

Description

# A METHOD OF FORMING A BARRIER LAYER BETWEEN A SILICON SUBSTRATE AND AN ALUMINUM ELECTRODE OF A SEMICONDUCTOR DEVICE

## BACKGROUND OF THE INVENTION

### (1) Field of the invention

The present invention relates to a barrier layer interposed between a silicon substrate and an aluminum electrode of a semiconductor device. The barrier layer is for preventing mutual diffusion of silicon and aluminum from occurring between the silicon substrate and the aluminum electrode.

In a semiconductor device such as an integrated circuit (IC) device, ohmic resistance appearing at a metallic contact between a silicon substrate and a metallic electrode must be as small as possible. As well known, a silicon oxide layer is formed on the silicon substrate as an insulating layer and then a metallic contact from the metallic electrode to the silicon substrate is made at a contact area provided on the silicon substrate by removing the silicon oxide layer therefrom. Hitherto, aluminum has been commonly used as the metallic electrode, forming an aluminum electrode, because the aluminum can be easily deposited, as an aluminum film, on the silicon substrate so as to have large adhesive strength against the silicon oxide layer. However, there has been a problem that mutual diffusion of aluminum and silicon has occurred between the silicon substrate and the aluminum electrode (aluminum film). That is, silicon atoms in the silicon substrate and aluminum atoms in the aluminum film mutually diffuse into the aluminum film and the silicon substrate respectively. Therefore, in a fabricating process of the IC device, the silicon in the silicon substrate tends to diffuse into the aluminum film and the aluminum in the aluminum layer tends to diffuse into the silicon substrate until the solubility of the diffused silicon in the aluminum film and that of the diffused aluminum in the silicon substrate increase up to a limit value (solubility limit) at a fabricating temperature of the IC device, respectively. This mutual diffusion causes to produce a rough surface of the silicon substrate, producing "pits" at an interface between the silicon substrate and the aluminum film. For preventing this mutual diffusion, an aluminum film including 1 to 2 weight percent (W%) of silicon is used for the metal electrode, so that the mutual diffusion is prevented in the aluminum film as long as the fabricating temperature is less than 550°C. However, at present , the fabricating temperature exceeds 550°C during the various fabricating processes of the IC device, so that silicon segregates in the aluminum film. This silicon segregation in the aluminum film occurs locally in limited regions called contact holes or via holes, usually produced near the contact area. Since the segregated silicon has high resistivity, the contact area is effectively reduced, causing an increase in the contact resistance. The increase of the contact resistance cannot be ignored in the IC device, particularly, where the IC device is a large scale integrated (LSI) circuit device or a very large scale integrated (VLSI) circuit device.

### (2) Description of the related art

To solve the above problem due to the mutual diffusion, a barrier layer has been provided between the silicon substrate and the aluminum layer. Generally, the barrier layer is required to have the following characteristics:

    1) Due to the barrier layer, the mutual diffusion of the silicon atoms and the aluminum atoms are prevented from occurring through the interface between the silicon substrate and the aluminum layer, even at a high processing temperature (this property is called the " barrier property", hereinafter); and

    2) the barrier layer has low resistivity and low contact resistance between the silicon substrate and the barrier layer and between the aluminum layer and the barrier layer.

A refractory metal compound such as refractory metal nitride, refractory metal carbide or refractory metal boride is used as the barrier layer, and such barrier layer is usually fabricated by a reactive sputtering technique, using a refractory metal as a target,and several kinds of gases. In the reactive sputtering, the barrier layer is fabricated under many sputtering conditions such as a partial pressure of respective gas, electric power applied to the target, a temperature of the silicon substrate and an electrostatic potential at the silicon substrate. Therefore, there was a tendency for the property of the barrier layer to be easily influenced by the tiny differences in the sputtering conditions. In particular, it was very hard to obtain an expected barrier property.

This problem has been improved by annealing the barrier layer in the atmosphere containing oxygen gas after sputtering. The main reason for using an atmosphere containing oxygen gas has been that at a high temperature, oxygen makes oxide at grain boundaries in the barrier layer, so as to prevent the mutual diffusion of silicon and aluminum from occurring through the grain boundaries. This is described in "Investigation of TiN Films for Diffusion Barriers in High Temperature Metallization" by Shuichi KANAMORI: in "Shinkuu" No. 29 (Sept. 1986). However, there has been still another problem in that the property of the annealed barrier layer has poor reproducibility because of contamination occurring on the barrier layer during the change of process from the sputtering to the annealing. Usually, the sputtering and the annealing is individually performed in a vacuum chamber of a reactive sputtering apparatus and in an annealing furnace respectively. Ihe reason is that the sputtering apparatus usually has a capacity of operating on only one wafer, for acting on a number of IC chips, taking 1 to 2 minutes.,. However, the annealing can be performed on approximately 50 wafers, taking about 50 minutes. Therefore, during the change of process from the sputtering to the annealing, the barrier layers on the wafer taken out from the vacuum chamber are contaminated by the dust and gas in the air, which results in a changing of properties of the barrier layers, in other words, results in producing low reproducibility of the expected property of the barrier layer.

The problem of the contamination would be solved if the process of transferring the wafer from the vacuum chamber to the annealing furnace became unnecessary. This trial has been done in two ways by using only the vacuum chamber. One of the two ways, which will be called a "first way" hereinafter, consisted only in raising the temperature, which will be called a "substrate temperature" hereinafter, of the silicon substrate set in the vacuum chamber without using the oxygen The other, which will be called a "second way" hereinafter, was to perform sputtering in an atmosphere including a very small percentage of oxygen without raising the substrate temperature.

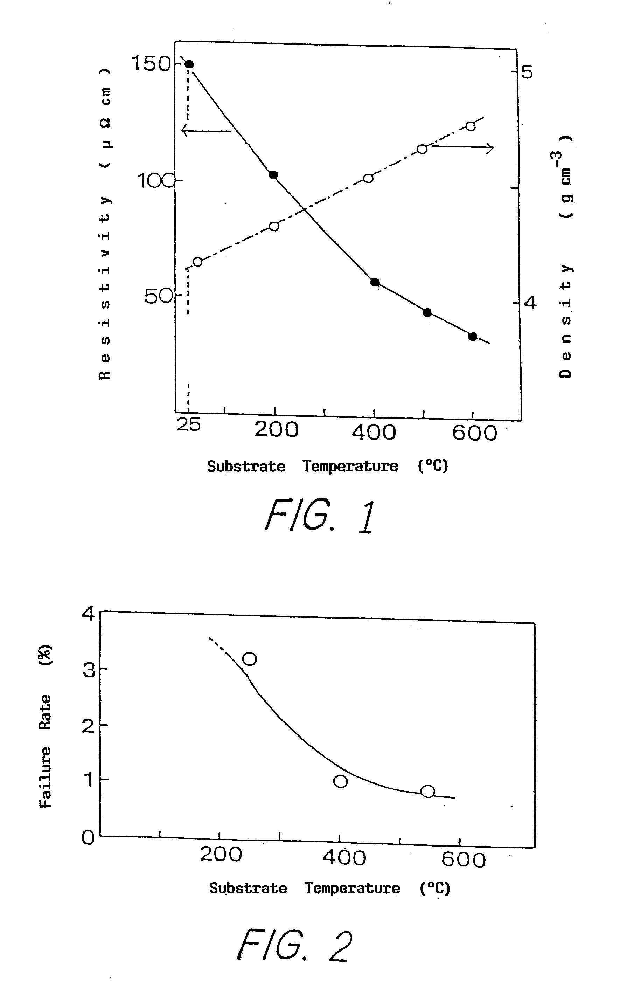

The first way is disclosed in a technical paper, which will be called "Ref. (1)" hereinafter, entitled "THE PROPERTIES OF REACTIVE SPUTTERED TiN FILMS FOR VLSI METALLIZATION", by the present inventor and others, on p205-211 of a publication for "VLSI Multilevel Interconnection (V-MIC) Conference" held in June 13-14 1988. According to the Ref. (1), when the barrier layer is formed by reactive sputtering at high substrate temperature in the vacuum chamber, the density of the formed barrier layer becomes high as the substrate temperature increases, which is shown in Fig. 1 of this application. That is, as shown in Fig. 1, the density of the titanium nitride (TiN) increases up to approximate 4.75 $g \cdot cm^{-3}$ when the substrate temperature is raised to 600°C, that is to say the density of TiN increases by 15% when the substrate temperature increases from 25°C to 600°C. The increase of the density may be because the crystallization of the TiN would be enhanced as the substrate temperature increases, and because of this increase of the density, the barrier property of the barrier layer increases. Fig. 1 also shows that the resistivity of TiN layer decreases to approximately 35 $\mu\Omega \cdot cm$ when the substrate temperature is raised up to 600°C, that is to say that the resistivity at 600°C decreases as low as one third of that at 25°C.

The Ref. (1) also shows a relationship between a failure rate and the substrate temperature. Here, , the failure rate is a rate newly derived by the inventor, for quantitatively evaluating the barrier property. According to Ref. (1), a pattern of a number of via holes, which is usually called Test Element Group (TEG), are initially formed on a test substrate consisting of a silicon substrate and an aluminum layer formed on the silicon substrate through a barrier layer of TiN. The via holes serve to test whether those holes are failured by the mutual diffusion of aluminum and silicon, by observing the failure state of the via holes through a microscope and counting the number of failured via holes. Then, the failure rate is defined as a rate of the number of the failured via holes to that of the total via holes.

(The failure rate will be also used in the explanation of the present invention hereinafter.) According to Ref. (1), the failure rate decreased as the substrate temperature increased. However, it is established that it is hard to decrease the failure rate to less than a value of 1% at 600°C of the substrate temperature. (In the fabrication of IC devices, it is not desirable to raise the substrate temperature to more than 600°C.)

The second way is disclosed in Japanese laid-open application, SHO 59-182208, filed on March 31, 1983 by Takeuchi et al. It has been well known that an oxygen gas has been used for increasing the barrier property. However, according to the laid-open application by Takeuchi, the oxygen gas has the drawback of increasing the resistivity of the barrier layer. Therefore, the laid-open application discloses that the flow rate of the oxygen gas should be less than 1% for keeping the resistivity to a value of less than 300 $\mu\Omega \cdot cm$. However, in the laid-open application, the substrate temperature is a room temperature and nothing is said about increasing the substrate temperature.

As a result, as far as the related art of the barrier layer, it has been known in practice that: raising the substrate temperature is effective for decreasing the resistivity and the failure rate, although, the failure rate is impossible to decrease to less than 1%; using the oxygen gas in the reactive sputtering is effective for decreasing the failure rate, although the oxygen gas has the defect of increasing the resistivity of the barrier layer, so that the flow rate of the oxygen gas must be limited to less than 1% to keep the resistivity to less than 300 $\mu\Omega \cdot cm$. Therefore, it has been believed by one skilled in the art that the barrier layer must be used for avoiding the mutual diffusion occurring. However there is a big problem in that it is almost impossible to expect the barrier layer to have a characteristic of decreasing the failure rate to less than 1% when the substrate temperature is raised to more than 600°C or when the resistivity is allowed to be more than 300 $\mu\Omega \cdot cm$. However, in the IC device, particularly in the case of LSI or VLSI device, more than 600°C substrate temperature and/or more than 300 $\mu\Omega \cdot cm$ resistivity are prohibited and furthermore in the case of LSI or VLSI device, the failure rate is strongly required to be less than 1%.

SUMMARY OF THE INVENTION

Therefore, an object of the present invention is to improve the characteristics of the barrier layer so as to simultaneously decrease the failure rate and the resistivity of the barrier layer without over-raising the substrate temperature.

Another object of the present invention is to improve the fabrication reliability of the aluminum electrodes formed to the silicon substrate with the barrier layer, in the fabrication process of the IC device.

Still another object of the present invention is to improve the product reliability of the IC device having the aluminum electrodes formed to the silicon substrate with the barrier layer.

The above objects are achieved by improving the reactive sputtering method of fabricating the barrier layer on the silicon substrate, so as to perform the sputtering by making an oxygen gas flow into the vacuum chamber of the conventional reactive sputtering apparatus and simultaneously raising the temperature of the silicon substrate..

That is, according to the present invention, the reactive sputtering for fabricating the barrier layer of TiN on the silicon substrate is performed by making an oxygen gas flow, at 5% flow ratio, into the vacuum chamber with usual gases including an inert gas (such as argon) and a reactive gas being either one of nitrogen gas, nitrogen compound gas, carbon compound gas and boron compound gas, simultaneously raising the substrate temperature to a value between 200°C to 600°C, so that a barrier layer of a refractory metal compound such as titanium nitride, titanium carbide or titanium boride is formed on the silicon substrate by the reactive sputtering technique, using a refractory metal such titanium as a target for the sputtering. After the forming the barrier layer made of TiN thus, the aluminum or aluminum alloy film is formed on the barrier layer for fabricating the electrode on the silicon substrate.

The TiN barrier layer is composed of many grains of titanium nitride, producing many grain boundaries. An average diameter of the grain depends on the substrate temperature in the sputtering process of the barrier layer so that the average diameter becomes larger as the substrate temperature increases. Therefore, the total area of grain boundaries decreases as the substrate temperature increases. Also, an oxygen atom has a feature to be easily trapped at the grain boundaries, producing titanium oxide. This titanium oxide produced at the grain boundaries causes to increase the resistivity of the barrier layer, improving the barrier property of the barrier layer. Therefore, when the substrate temperature is raised , a small amount of oxygen gas is sufficient to obtain the same effect as using a large amount of oxygen gas at the low substrate temperature. Therefore, the resistivity of the barrier layer which is fabricated at a higher substrate temperature does not become larger than that at the substrate temperature of 25°C, even though a large amount of oxygen gas is used.

According to an experiment by the present inventor, the failure rate is decreased so as to be smaller than 1% when oxygen flow ratio is 2 to 5% and the substrate temperature is kept at a temperature between 260 to 550°C. Also, the resistivity of the barrier layer fabricated under the same flow ratio of oxygen and substrate temperature, is less than $100\mu\Omega\cdot$cm.

To evaluate the reactive sputtering method of the present invention, a diode composed of an aluminum electrode formed on a silicon substrate through a TiN barrier layer was prepared, and heat treatment of the diode was performed at 480°C for 90 min for measuring the leakage current of the diode before and after the heat treatment. As a result, it has been confirmed that there was no difference of the leakage current before and after the heat treatment. This means that the heat resisting property of the barrier layer is high enough, in other words, no mutual diffusion occurs in the actual usage of the diode having the TiN barrier layer.

BRIEF DESCRIPTION OF THE DRAWINGS

Fig. 1 is a graph showing the influence of a substrate temperature on the density and the resistivity of the TiN barrier layer;

Fig. 2 is a graph showing the variation in the failure rate of a barrier layer to the change of a substrate temperature;

Fig. 3 is a schematic drawing of a conventional reactive sputtering apparatus used for fabricating a barrier layer;

Fig. 4(a) is a schematic cross-sectional view of a silicon substrate;

Fig. 4(b) is a schematic cross-sectional view of a first silicon substrate consisting of the silicon substrate and an insulating layer formed on the silicon substrate, providing a contact hole;

Fig. 4(c) is a schematic cross-sectional view of a second silicon substrate fabricated by forming a contact layer on the first silicon substrate;

Fig. 4(d) is a schematic cross-sectional view of a barrier layer formed on the second silicon substrate;

Fig. 4(e) is a schematic cross-sectional view of an aluminum electrode formed on the second silicon substrate through the barrier layer;

Fig. 5 is a graph showing a relationship between the resistivity of a barrier layer and the flow rate of an oxygen gas which flows during the reactive sputtering is performed, making a substrate temperature as a parameter;

Fig. 6 is a graph showing a relationship between the failure rate of a barrier layer and the flow rate of an oxygen gas which flows while the reactive sputtering is performed, making a substrate temperature as a parameter;

Fig. 7 is a schematic cross-sectional view of a diode comprising an aluminum electrode, a TiN barrier layer and an n-type region in a p-type silicon substrate;

Fig. 8(a) is a histogram of the leakage current of the diode after heat treatment when a barrier layer formed in the diode is fabricated under an oxygen-free condition, and

Fig. 8(b) is a histogram of the leakage current of the diode after heat treatment when a barrier layer formed in the diode is fabricated under 4 sccm flow rate of an oxygen gas and 550°C of a substrate temperature.

DESCRIPTION OF THE PREFERRED EMBODIMENT

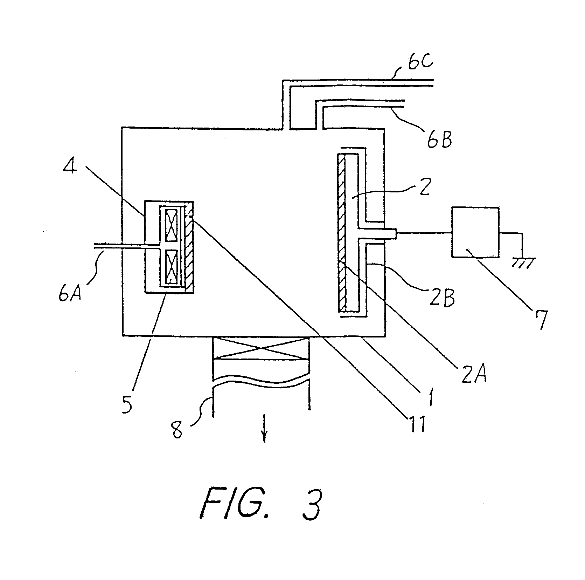

A method for forming a barrier layer on a silicon substrate by reactive sputtering technique, an application of the barrier layer to an aluminum electrode and the characteristics of the barrier layer will be described in reference to Figs. 3 to 8.

Fig. 3 shows a schematic drawing of a conventional reactive sputtering apparatus used in a reactive sputtering method embodying the present invention, for forming a barrier layer. A vacuum chamber 1, made of stainless steel for instance, contains an electrode 2 and a sample holder 4. On the electrode 2, a target 2A formed as disk having a diameter of 8" and composed of refractory metal such as titanium (Ti) of four nine purity is fixed. The electrode 2 has an electric shield 2B connected to the vacuum chamber 1 for obtaining the same electric potential as that on the electrode 2. On the sample holder 4, a silicon substrate 11 having a diameter of 4" is fixed for forming a barrier layer on the silicon substrate 11 in such that a surface of the silicon substrate 11 faces to a surface of the titanium target 2A with a adequate distance, for instance, 5.5 cm. The silicon substrate 11 is maintained at 350°C by using a heater 5. However, the substrate temperature can be controlled up to 600°C. The vacuum chamber 1 is evacuated in high vacuum by a vacuum pump, not depicted, through an exhaust tube 8. Then, three kinds of gases are introduced into the vacuum chamber 1 through three gas inlets 6A, 6B and 6C and mixed in the vacuum chamber 1, and the mixed gas is exhausted through the exhaust tube 8. Total pressure of the mixed gas is kept at 1-5 mm Torr. An inert gas such as argon gas is introduced through the gas inlet 6A. Nitrogen gas forms a reactive gas introduced through the gas inlet 6B when a titanium nitride (TiN) is formed as a barrier layer. Oxygen gas is introduced through the gas inlet 6C. The flow ratios of argon, nitrogen and oxygen are 20-48%, 50-75% and 2-5% respectively. When negative high voltage of 400-500V is applied to the electrode 2 from a DC electric power source 7, plasma is generated between the electrode 2 and silicon substrate 11.

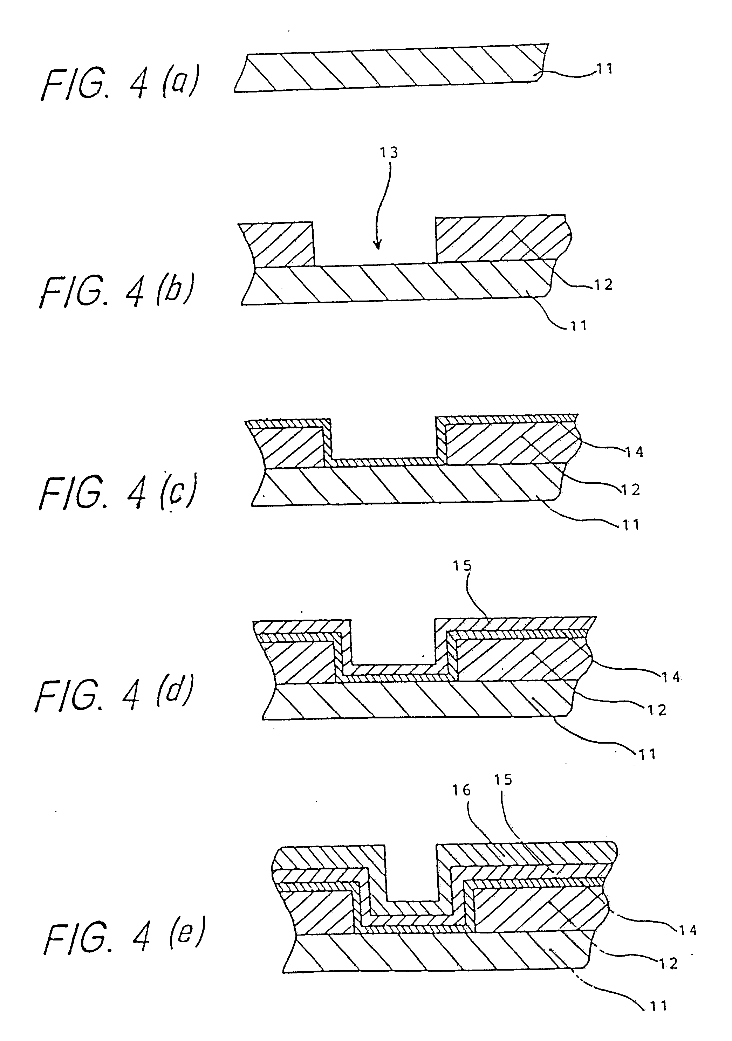

Next, the fabricating steps of an aluminum electrode will be described in reference to Figs. 4(a) to 4(e). Figs. 4(a) to 4(e) are cross-sectional views showing the fabricating steps. Fig. 4(a) shows a silicon substrate 11 on which an aluminum electrode will be formed. An insulating layer 12 composed eg. of silicon dioxide or phosphosilicate glass (PSG) is formed on the silicon substrate 11, and a contact hole 13 for making electrical contact between the aluminum electrode and the silicon substrate is formed in the insulating layer 12 by a conventional lithography, as shown in Fig. 4(b). The sample in Fig. 4(b) will be called a first silicon substrate hereinafter. Then, in order to obtain a good ohmic contact between the aluminum electrode and the silicon substrate 11, a contact layer 14 is formed on the silicon substrate 11 appearing in the contact hole 13 and on the insulating layer 12 as shown in Fig. 4(c). This contact layer 14 is a thin layer of about 10 nm in thickness and is composed of titanium, aluminum or doped polysilicon. The contact layer 14 does not have the barrier property at all. The properties of the contact layer has been disclosed by the present inventor in Japanese patent No. SHO 62-165795, in July, 2, 1987. The sample shown in Fig. 4(c) will be called a second silicon substrate hereinafter.

The second silicon substrate is placed in the sample holder 4 in the vacuum chamber 1 shown in Fig. 3. The DC power of 3-7 KW is supplied to the titanium target 2A, then the titanium target 2A is sputtered by the plasma, so that the sputtered titanium reacts with the nitrogen gas. As a result, a titanium nitride barrier layer 15 is deposited on the contact layer 14 so as to have a thickness of 50-200 nm, as shown in Fig. 4(d). Finally, an aluminum or aluminum alloy electrode layer 16 is deposited on the barrier layer 15 by a conventional technique, as shown in Fig. 4(e).

The contact layer 14, the barrier layer 15 and the electrode layer 16 are patterned so as to form a definite electrode and wiring, not depicted, of an IC device. As seen from Fig. 4(e), the aluminum electrode layer 16 is connected to the silicon substrate 11 through the barrier layer 15 and the contact layer 14.

In this embodiment, titanium is used as the target, although refractory metal such as tantalum (Ta), zirconium (Zr), hafnium (Hf), tungsten (W), molybdenum (Mo) can be used instead of titanium. The following materials can be used for the barrier layer other than titanium nitride (TiN): titanium carbide (TiC), titanium boride (TiB), corresponding to Ti target; tantalum nitride (TaN), tantarum carbide (TaC) and tantalum boride (TaB), corresponding to Ta target; zirconium nitride (ZrN), zirconium carbide (ZrC) and zirconium boride (ZrB), corresponding to Zr target; hafnium nitride (HfN), hafnium carbide (HfN) and hafnium boride (HfB), corresponding to Hf target; tungsten nitride (WN), tungsten carbide (WC) and tungsten boride (WB), corresponding to W target; and molybdenum nitride (MoN), molybdenum carbide (MoC) and molybdenum boride (MoB), corresponding to Mo target.

In order to form a barrier layer composed of nitrogen compound, carbon compound or boron compound, nitrogen compound gas such as ammonium gas ($NH_3$), carbon compound gas such as methane ($CH_4$) or boron compound gas such as diboran ($B_2H_6$) are used, respectively, instead of the nitrogen gas.

After forming the aluminum electrode layer 16, an extra heat treatment was required for improving the characteristics of the barrier layer in the prior art. However, applying the above method of the present invention to the reactive sputtering technique, the heat treatment is no longer required.

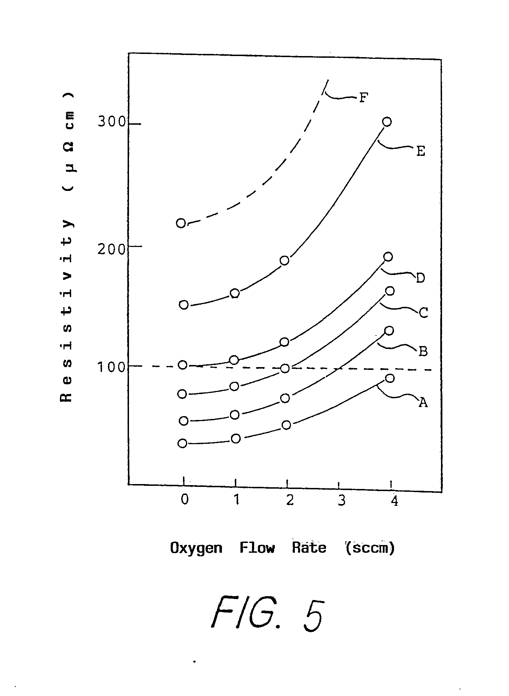

As stated above the oxygen gas in the vacuum chamber played an important role to enhance the barrier property of the barrier layer; however, the use of the oxygen gas had disadvantage that the resistivity of the barrier layer increased at the same time. Regarding the disadvantage, systematic experiments were carried out to find an influence of oxygen on the resistivity of the barrier layer. Fig. 5 shows the relationship between the resistivity of the barrier layer and the flow rate of the oxygen gas by changing the substrate temperature. The value of oxygen flow rate is equivalent to the volume percentage of oxygen gas called the flow ratio, since the total flow rate is set to 100 sccm. In Fig. 5, five experimental curves A, B, C, D and E are provided by connecting measured points of the resistivity in correspondence to the flow rates 0, 1, 2 and 4 sccm of the oxygen gas respectively, and a curve F is provided in estimation - based on a measured resistivity corresponding to "0" flow rate- that the resistivity would vary along the curve F if the flow rate of the oxygen gas changes from 0 to 4. The curves A, B, C, D, E and F correspond to the substrate temperature 550°C, 410°C, 350°C, 260°C, 125°C and 25°C, respectively. As seen from these curves A, B, C, D, E and F, the resistivity of the barrier layer increases as the flow rate of oxygen increases. It is concluded that: when the flow rate of oxygen is constant, the resistivity of the barrier layer becomes small as the substrate temperature is raised ; and when the resistivity of the barrier layer is constant, the substrate temperature becomes high as the flow rate increases.

It can be found from the curves A, B and C in Fig. 5 that if the flow rate of the oxygen gas and the substrate temperature are set so as to be less than 4 sccm and higher than 350°C respectively, the resistivity can be set within a value smaller than $100\mu\Omega \cdot cm$.

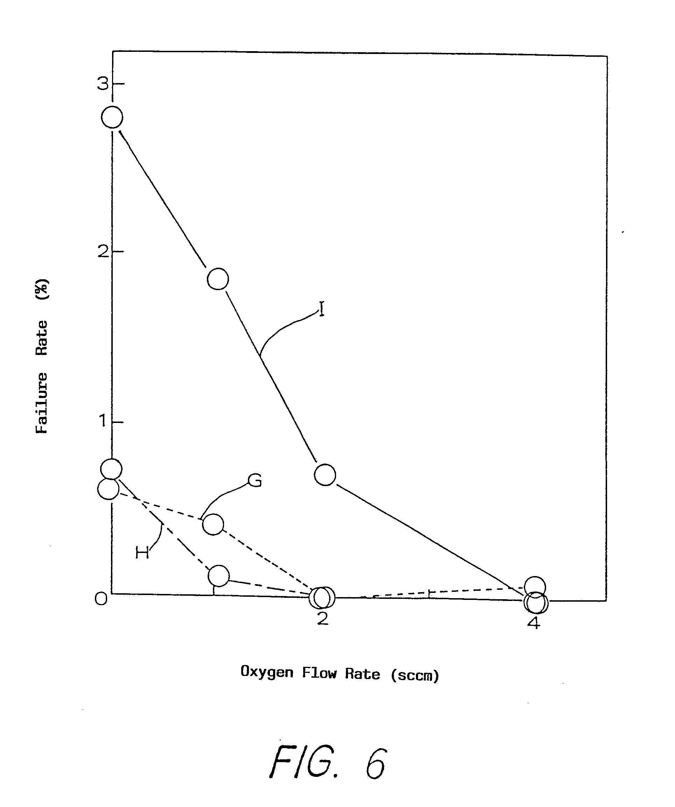

Fig. 6 shows the failure rate varying with the flow rates, in correspondence to three substrate temperatures. Curves G, H and I in Fig. 6 correspond to the substrate temperatures 260°C, 410°C and 550°C respectively. A measurement of the barrier property of the barrier layer is carried out, using the same test pattern as used in Ref. (1). In this test pattern, three thousand via holes are provided on a silicon substrate, and the via holes are observed with an optical microscope. If at least one etch pit is observed in a via hole, the via hole is counted as a failured via hole. Then, the number of failured via holes is counted, so that the failure rate is obtained as the percentage of the failured via holes in the total three thousand via holes. As seen from Fig. 6, the failure rate becomes smaller as the flow rate of the oxygen gas increases. It can be found from the curve I in Fig. 6 that when the substrate temperature is 260°C, 3% of the failure rate at 0 sccm of the flow rate decreases to almost 0% of the failure rate as the flow rate increase from 0 to 4 sccm. When the substrate temperatures is raised up to 410°C or 550°C, the failure rates become 0% if the flow rate of the oxygen gas exceeds 2 sccm, as shown by curves G and H respectively.

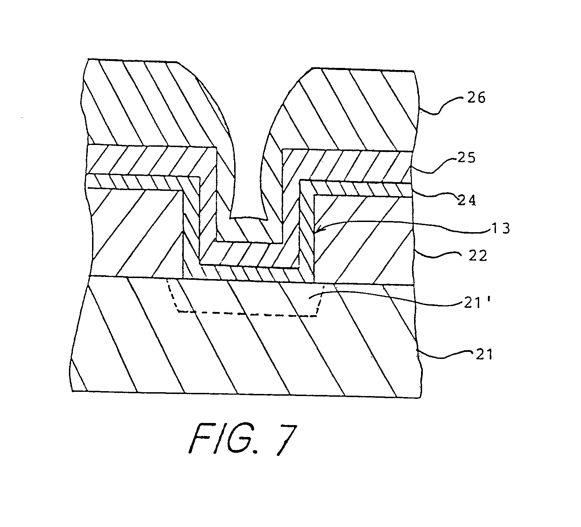

In order to verify whether the mutual diffusion of aluminum and silicon occurs in a TiN barrier layer fabricated as described in reference to Fig. 3, the heat resisting property of an aluminum electrode was measured, including the TiN barrier layer by performing heat treatment in a vacuum environment at 480°C for 90 min. As a result, it was confirmed that the mutual diffusion did not occur. This fact was confirmed by measuring the leakage current of a diode shown in Fig. 7. Fig. 7 shows a schematic cross-sectional view of a diode which has an aluminum electrode as shown in Fig. 4. A plurality of diodes, each being same as the diode shown in Fig. 7, are fabricated on a test pattern in the same way as used for the measurement of the failure rate. The diode has a p-n junction fabricated by arsenic ion implantation performed into a p-type silicon substrate 21, using energy of 70KeV and dose of 4 x $10^{15}cm^{-2}$. An n-type region 21' is formed in the p-type silicon substrate 21 so as to have a thickness of 0.34$\mu$m, by the ion implantation as indicated by a dotted line in Fig. 7. A contact hole 13 having a diameter of 1.2$\mu$m is provided in a silicon dioxide layer 22 having a thickness of 1.0$\mu$m. A contact layer 24 composed of titanium having a thickness of 20 nm is formed on both the n-type region 21' and the silicon dioxide layer 22, followed by forming a TiN barrier layer 25 and an Al electrode layer 26 so as to have a thickness of O.1$\mu$m and 1.0$\mu$m respectively. Then the heat treatment of the diode is performed in a vacuum environment at 480°C for 90 min.

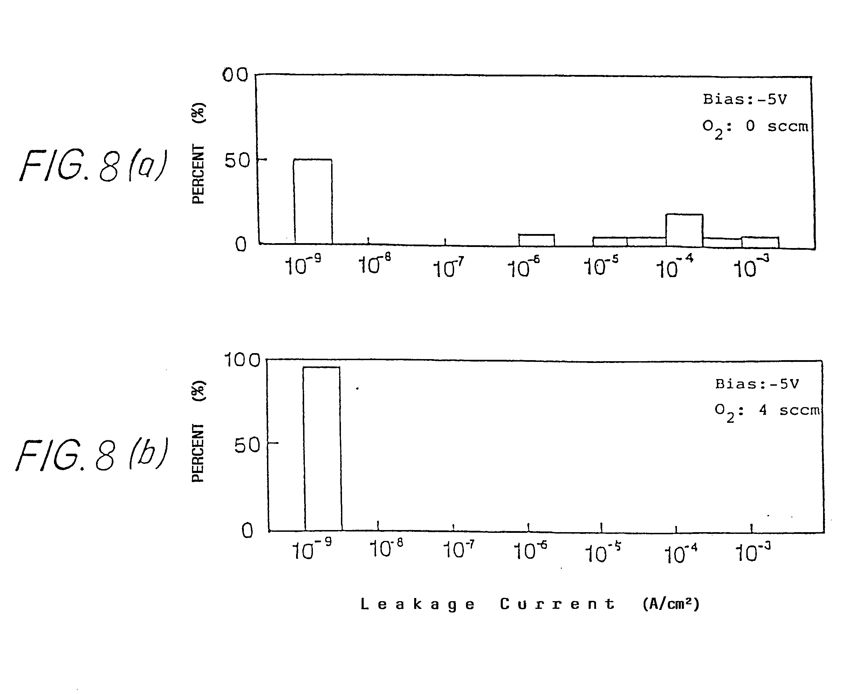

The leakage current is measured under a reverse bias of 5V for all diodes on the test pattern. Figs. 8(a) and 8(b) are histograms showing the results of the measurement of the leakage current. Fig. 8(a) shows a histogram of the leakage current of the diodes each having a barrier layer fabricated under a condition of oxygen free and 550°C substrate temperature. It is seen in Fig. 8(a) that the leakage current of the diodes is scattered from $10^{-9}$ to $10^{-3}$ A cm$^{-2}$. It is considered that the scatter of the leakage current is caused by the damage of regions near by the p-n junction because of the mutual diffusion of aluminum and silicon occurring during the heat treatment. Fig. 8(b) shows a histogram of the leakage current of the diodes which includes a barrier layer fabricated under a condition of 4 sccm oxygen flow rate and 550°C substrate temperature. In the case of Fig. 8(b), the leakage current of the diodes is concentrated almost on a value of $10^{-9}$ A cm$^{-2}$, in other words, the leakage current is not scattered, which means that the damage of regions near by the p-n junction does not occur because the mutual diffusion of aluminum and silicon is suppressed by the barrier layer.

**Claims**

1. A method of forming an aluminum or aluminum alloy electrode layer on a silicon substrate; said method comprising the steps of:
forming an insulating layer having contact hole for making the electrode layer contact with the silicon substrate, on the silicon substrate, producing a first silicon substrate;
placing said first silicon substrate in a reactive sputtering means;
placing a target composed of a refractory metal used for performing reactive sputtering, in the reactive sputtering means;
supplying a mixed gas including an inert gas, a reactive gas and an oxygen gas into the reactive sputtering means;
controlling a temperature of said second silicon substrate so as to maintain said temperature to a value between 350°C and 600°C ;
performing the reactive sputtering in the reactive sputtering means for forming a barrier layer composed of a refractory metal compound, on said first silicon substrate, said barrier layer being for preventing silicon atoms in the silicon substrate from diffusing into the electrode layer, and preventing aluminium atoms in the electrode layer from diffusing into the silicon substrate; and

forming an aluminum or aluminum alloy layer on said barrier layer.

2. A method according to claim 1 further comprising a step of forming a contact layer, in said contact hole, between said first silicon substrate and said barrier layer, for making, in said contact hole, an ohmic contact between said first silicon substrate and said barrier layer, said contact layer being selected from the group consisting of titanium, polysilicon and aluminum.

3. A method according to claim 1, wherein said reactive gas in said step of supplying a mixed gas, is selected from the group consisting of a nitrogen gas, a nitrogen compound gas, a carbon compound gas and a boron compound gas.

4. A method according to claim 1, wherein said refractory metal composing said target in said step of setting a target, is selected from the group consisting of titanium, zirconium, hafnium, tungsten and molybdenum.

5. A method according to claim 1, wherein said insulating layer is selected from the group consisting of composed of silicon dioxide, a phosphosilicate glass, silicon nitride and a borophosphosilicate glass.

6. A method of forming an aluminum or aluminum alloy electrode layer on a silicon substrate; said method comprising the steps of:

forming an insulating layer having a contact hole for making the electrode layer contact with the silicon substrate, on the silicon substrate, producing a first silicon substrate;

forming a contact layer of titanium on said first silicon substrate so as to have a thickness less than 20 nm, producing a second silicon substrate; placing said second silicon substrate in a reactive sputtering means;

placing a target composed of a titanium metal used in the reactive sputtering, in said reactive sputtering means;

supplying a mixed gas consisting of an argon gas, a nitrogen gas and an oxygen gas to said reactive sputtering means;

controlling a temperature of said second silicon substrate so as to be kept to a value between 350°C and 600°C;

performing the reactive sputtering by said reactive sputtering means for forming a barrier layer consisting of a titanium nitride produced during the reactive sputtering, on said second silicon substrate, said barrier layer being for preventing silicon atoms in the silicon substrate from diffusing into the aluminum electrode and aluminum atoms in the aluminum electrode from diffusing into the silicon substrate, and said contact layer being for making said barrier layer contact with the silicon substrate; and

forming the aluminum or aluminum alloy layer on said barrier layer.

7. A method according to claim 6, wherein said oxygen gas used in said step of supplying a mixed gas, is 1-5% in volume of said mixed gas.

8. A method according to claim 6, wherein said insulating layer is selected from the group consisting of composed of silicon dioxide, a phosphosilicate glass, silicon nitride and a borophosphosilicate glass.

9. A method according to claim 6, wherein said barrier layer formed in said step of performing the reactive sputtering for forming a barrier layer, has a thickness of 50 nm to 200 nm.

FIG. 1

FIG. 2

FIG. 3

FIG. 4 (a)

FIG. 4 (b)

FIG. 4 (c)

FIG. 4 (d)

FIG. 4 (e)

FIG. 5

*FIG. 6*

FIG. 7

FIG. 8 (a)

FIG. 8 (b)

Leakage Current (A/cm²)

EP 0 353 120 A1

European Patent
Office

**EUROPEAN SEARCH REPORT**

Application Number

EP 89 40 1978

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | PROCEEDINGS OF THE FOURTH INTERNATIONAL IEEE VLSI MULTILEVEL INTERCONNECT CONFERENCE, Santa Clara, CA, 15th-16th June 1987, pages 344-350, IEEE, New York, US; B. LEE et al.: "Effect of oxygen on the diffusion barrier properties of TiN" * Whole article * | 1,6 | H 01 L 21/60<br>H 01 L 21/90<br>H 01 L 23/52 |
| A | IDEM | 2-5,7-9 | |
| Y | JOURNAL OF VACUUM SCIENCE & TECHNOLOGY A, vol. 3, no. 4, July/August 1985, pages 1797-1803, American Vacuum Society, Woodbury, New York, US; M. WITTMER: "Properties and microelectronic applications of thin films of refractory metal nitrides" * Page 1799, column 2, lines 28-34; table 1 * | 1,6 | |
| A | IDEM | 4 | TECHNICAL FIELDS SEARCHED (Int. Cl.5)<br><br>H 01 L |

The present search report has been drawn up for all claims

| Place of search | Date of completion of the search | Examiner |
|---|---|---|
| THE HAGUE | 17-10-1989 | PHEASANT N.J. |